# EUROPÄISCHE PATENTSCHRIFT

(11) **EP 1 716 212 B1**
(45) Veröffentlichungstag und Bekanntmachung des Hinweises auf die Patenterteilung: **12.08.2009**
(21) Anmeldenummer: 05707890.9
(22) Anmeldetag: 24.01.2005
(51) Int. Cl.: C09D 167/08, H01B 3/42, H05K 3/28

(54) **ÜBERZUGSLACK**
OVERCOAT LACQUER
VERNIS DE COUVERTURE

(30) Priorität: 09.02.2004 DE 102004006239
(43) Veröffentlichungstag der Anmeldung: 02.11.2006
(73) Patentinhaber: Altana Electrical Insulation GmbH, 46483 Wesel (DE)
(72) Erfinder: LIENERT, Klaus-Wilhelm, 22763 Hamburg (DE); SCHMIDT, Gerold, 22145 Hamburg (DE); TÖDTER-KÖNIG, Sascha, 22763 Hamburg (DE)
(74) Vertreter: Fitzner, Uwe
(86) Internationale Anmeldenummer: PCT/EP2005/050383
(87) Internationale Veröffentlichungsnummer: WO 2005/075586

(56) Entgegenhaltungen:
- US-A- 3 211 585
- US-A- 3 523 820
- US-A- 5 854 334
- DATABASE WPI Section Ch, Week 197539 Derwent Publications Ltd., London, GB; Class A23, AN 1975-64727W XP002323459 -& JP 50 069193 A (TEIJIN LTD) 9. Juni 1975 (1975-06-09)
- DATABASE WPI Section Ch, Week 197828 Derwent Publications Ltd., London, GB; Class A21, AN 1978-50364A XP002323460 -& JP 53 061629 A (MITSUBISHI ELECTRIC CORP) 2. Juni 1978 (1978-06-02)

## Beschreibung

Die vorliegende Erfindung betrifft einen lufttrocknenden Lack der sich insbesondere zum Überzug von Flachbaugruppen in der Elektronik, Hybriden, SMD-Baugruppen, und bestückten Leiterplatten eignet, die einer erhöhten thermischen Belastung ausgesetzt sind. Außerdem kann der Lack zum Tränken von elektrischen Wicklungen oder als Schutzlack für elektrische Wicklungen eingesetzt werden.

Ein Überzugslack für Flachbaugruppen, Hybriden, SMD-Baugruppen, sowie andere Komponenten, die auf Leiterplatten zum Einsatz kommen, muß die lackierten Teile vor Feuchte, Chemikalien, Staub usw. schützen. Außerdem sollte durch die Schutzschicht die Klima- und Kriechstromsicherheit elektronischer Baugruppen erhöht werden. Die thermische Belastbarkeit muß dem Einsatzgebiet angepaßt sein. Übliche Lacke haben einen Temperaturindex (TI) von 130. Gewünscht wird, insbesondere von der Automobilindustrie ein Überzugslack mit einem TI größer 155. Eine gute Haftung auf verschiedenen Substraten wird als selbstverständlich angenommen. Die Verarbeitung geschieht üblicherweise im Select-, Coat-, Selektivtauch-, Sprüh- oder Spritzverfahren. Mit einem derartigen Lack werden Trockenfilmstärken ab 10 ηm erhalten.

Stand der Technik ist die Verwendung von luft- oder ofentrocknenden Lacken. Das Bindemittel ist üblicherweise ein Alkyd-, ein Acryl-, oder ein Polyurethanharz. Alkydharze sind als Oberflächenschutz seit langem bekannt und auch beschrieben (W.Oburger, Die Isolierstoffe der Elektrotechnik, Springer 1957; W. Tillar Shugg, Handbook of Electrical and Electronic Insulating Materials, IEEE Press 1995).

Alkydharze können als solche oder auch als modifizierte Harze (Imid, Urethan) ohne oder mit zusätzlichen Härtern (Melamin-, Phenolharze, (blockierte) Isocyanate) in organischen Lösemitteln formuliert werden. Diese Lacke sind niedrigviskos und enthalten neben Bindemitteln Katalysatoren und Additive. Alkydharze sind bekannt als nicht besonders temperaturstabil, haben aber den Vorteil, daß sie bei der richtigen Bindemittelzusammensetzung lufttrocknend sind und damit eine kostengünstige Verarbeitung erlauben.

Werden in verzweigten Polyesterharzen oder modifizierten Polyesterharzen Tris-(2-Hydroxyethyl)-Isocyanurat eingebracht, erhält man Produkte, die thermisch höherwertig sind (K-W. Lienert, Poly(ester-imide)s for industrial use, S. 48, in Progress in polyimide chemistry, Vol. 141, 1999).

JP 50069193 und JP 53061629 offenbaren Alkydharze, die jedoch nicht mit Toluylendiisocyanat modifiziert sind, zudem ist es aus JP 53061629 nicht bekannt, Naphthalindicarbonsäure zu verwenden.
Aus der US 3,211,585 und der US 3,523,820 ist es bekannt, Polyesterharze mit Polyisocyanaten zu modifizieren, jedoch ist hieraus die Verwendung von Naphthalindicarbonsäure zu deren Aufbau nicht bekannt.

Außerdem wird in der EP 0 813 580 beschrieben, daß die Verwendung 2,6-Naphthalindicarbonsäurestrukturen anstatt der üblichen Terephthalatstrukturen in Polyestern und modifizierten Polyestern ebenfalls zu einer Verbesserung der thermischen Eigenschaften führt.

Die vorliegende Erfindung hat sich die Aufgabe gestellt, einen lufttrocknenden, niedrigviskosen Überzugslack zur Beschichtung von Flachbaugruppen, Hybriden, SMD-Baugruppen, usw. zur Verfügung zu stellen, der sich auf den üblichen Anlagen verarbeiten läßt und einen TI nach IEC 60216 von mindestens 155 aufweist.

Diese Aufgabe wird durch einen Überzugslack gelöst, welcher
a) ein Bindemittel bestehend aus einem Alkydharz aufgebaut aus
   1. 33,0 - 50,0 Gew.-%, bevorzugt 37,0 - 45,0 Gew.-%, besonders bevorzugt 38,0 - 43,0 Gew.-% Tris-(2-Hydroxyethyl)-Isocyanurat,
   2. 14,0 - 20,0 Gew.-%, bevorzugt 15,0 - 19,0 Gew.-%, besonders bevorzugt 16,0 - 18,0 Gew.-% 2,6-Naphthalindicarbonsäuredimethylester,
   3. 34,0 - 47,0 Gew.-%, bevorzugt 38,0 - 44,0 Gew.-%, besonders bevorzugt 40,0 - 42,0 Gew.-% Tallölfettsäure,
   4. 1,0 - 15,0 Gew.-% eines Modifizierungsmittels, wobei die Gew.-% jeweils auf 100,0 Gew.-% addiert werden, und wobei das Modifizierungsmittel ein Gemisch von 2,6- und 2,4-Toluylendiisocyanat ist,
b) wenigstens ein Lösemittel oder wenigstens ein technisches Lösemittelgemisch hiervon enthaltend wenigstens ein kohlenwasserstoffhaltiges Lösemittel und
c) wenigstens ein Sikkativ oder wenigstens ein Gemisch von Sikkativen und ein oder mehrere Antihautmittel,
enthält.

Erfindungsgemäß wird das Alkydharz in den Lösemitteln zusammen mit den Sikkativen und den anderen Hilfsstoffen gelöst. Dadurch erhält man einen Lack, der abhängig von der Bindemittelkonzentration und Lösemittelzusammensetzung unterschiedliche Viskositäten hat. Üblicherweise haben Lacke die zum Beschichten von Flachbaugruppen in der Elektronik, Hybriden und SMD-Baugruppen Viskositäten zwischen 100 mPas und 400 mPas, je nach Anwendung, Verarbeitungstechnologie und gewünschter Schichtstärke.

Die Herstellung von Alkydharzen ist allgemein bekannt und kann in diversen Standardwerken der chemischen Literatur nachgelesen werden. Dabei werden die Komponenten mit oder ohne Veresterungskatalysator üblicherweise auf Temperaturen zwischen 190 und 240°C erhitzt. Die Reaktion wird üblicherweise unter Schutzgas durchgeführt. Um die Austragung des gebildeten Wassers zu erleichtern, kann ein Azeotrop, Schleppmittel und/oder Vakuum verwendet werden. Die Kontrolle des Kondensationverlaufs wird üblicherweise durch die Bestimmung der Säurezahl und/oder der Kondensationsviskosität durchgeführt.

Die aus den beschriebenen Komponenten aufgebauten Alkydharze können erfindungsgemäß modifiziert sein.

Zur Modifizierung von Alkydharzen können verschiedene Komponenten eingesetzt werden, die mit den Hydroxyl- und/oder den Säuregruppen der Harze reagieren. Mit den Hydroxylgruppen reagieren Mono- oder Polyisocyanate, die aromatisch, aliphatisch oder cycloaliphatisch sein können, wie z.B. Phenylisocyanat, Naphthylisocyanat, 2,6- und 2,4-Toluylendiisocyanat oder ein Gemisch aus beiden, 4,4'-Diisocyanatodiphenylmethan, 1,6-Hexamethylendiisocyanat, Isophorondiisocyanat, usw.. Andere mit den Hydroxylgruppen reagierende Komponenten sind zum Beispiel Resole oder Melaminharze. Technisch verfügbar sind eine große Anzahl solcher Verbindungen.

Die Säuregruppe der Alkydharze kann leicht mit Epoxidharzen reagieren. Geeignete Epoxydharze sind z.B. Bisphenol-A- und Bisphenol-F-diglycidether, Limonenoxid, 3,4-Epoxycyclohexylmethyl-3',4-epoxycyclohexancarboxylat, sowie monofunktionelle Oxirane wie z.B. Phenylglycidether, Glycidether langkettiger Alkohole oder von Polyalkylenglykolen.
Eine weitere Modifikation der Alkydharze besteht in ihrer Verkochung mit natürlichen trocknenden Ölen, mit natürlichen Harzen, mit Maleinsäureanhydrid usw. Die Aufzählung dieser Möglichkeiten ist beispielhaft und grenzt die erfindungsgemäßen Lackbindemittel nicht ein.

Als Lösemittel oder Lösemittelgemisch (Komponente b)) kommen in Betracht aliphatische und/oder aromatische Kohlenwasserstoffgemische, die in der Lackchemie bekannt sind, wie z.B. Shellsol D 25 und D 40, Solvesso 100 und Solvesso 150, Toluol, Xylor and diese enthaltenden Destillationsschnitte. Diese Lösemittel werden üblicherweise, aber nicht zwingend, in einer Mischung mit Estern, Ketonen, Lactonen, sowie anderer typischer Lacklösemittel verwendet. Folgende Aufzählung soll die Vielfalt der einsetzbaren Verbindungen aufzeigen: Als Ester sind hier zu nennen Ethyl-, Isopropyl und Butylacetat, Ketone wie Ethylmethylketon, Isopropylmethylketon, Isoamylmethylketon, Isophoron sind ebenfalls einsetzbar. Gammabutyrolacton ist ein Repräsentant der Klasse der Lactone. Andere typische Lacklösemittel sind Hydroxyether wie z.B. Methoxypropanol und -butanol, Etherester, wie z.B. Methoxypropylacetat-2, cyclische Ester wie z.B. Propylen- und Gylcerincarbonat. Es sei hiermit auf die Fachliteratur, die Lösemittel für Lacke betrifft, hingewiesen.

Die Komponente c) enthält Metallsalze, wie z.B. Blei-, Cobalt-, Zirkonoctoat, Mangan-, Vanadium, Calciumnaphthenat, oder Kombinationen dieser Sikkative, welche die Vernetzung der Alkydharze durch Luftsauerstoff katalysieren.
Die in der Komponente c) enthaltenen Antihautmittel, wie z.B. Ethylmethylketoxim, Tocopherol, Ascinin ® Antiskin VP 242 (erhältlich über Fa. Borchers, Deutschland), verhindern die Bildung einer Hautschicht auf der Lackoberfläche während der Lagerung der erfindungsgemäßen Lacke in Gebinden.
Üblicherweise und auch abhängig von dem Einsatz des Lackes, können Alkydharzlacke gegebenenfalls Co-Katalysatoren, Korrosionsinhibitoren, Entschäumer, Verlaufs- und Netzmittel enthalten. Es sei hiermit auf die einschlägigen Lackhandbücher verwiesen.

Zur Herstellung des erfindungsgemäßen Überzugslackes wird vorzugsweise das bestehende Bindemittel in Komponente b) gelöst, ggf. modifiziert, ggf. erwärmt und anschließend Komponente c) zugesetzt.

Der erfindungsgemäße Überzugslack kann vorzugsweise zum Beschichten von elektrischen Drähten, elektrischen Wicklungen, als Überzug in Flachbaugruppen in der Elektronik, Hybriden, SMD-Baugruppen, bestückten Leiterplatten und zur Imprägnierung von elektrischen Wicklungen verwendet werden.

Im folgenden wird die Erfindung unter Bezugnahme auf Beispiele näher beschrieben. Die Ausprüfung erfolgt nach DIN und IEC-Normen.

### Beispiele

### Beispiel 1

Aus 1044 g Tris-(2-Hydroxyethyl)-Isocyanurat (THEIC), 460 g 2,6-Naphthalindicarbonsäuredimethylester (NDC), 1085 g Tallölfettsäure und eines üblichen Veresterungskatalysators wird ein Alkydharz hergestellt, das eine Säurezahl kleiner 5 mg KOH/g hat. Das Harz wird in 700 g Methoxypropylacetat-2 und 1700 g Lackbenzin aufgelöst. Die Lösung wird mit 208 g eines technischen Gemisches von 2,6- und 2,4-Toluylendiisocyanat versetzt und erwärmt, bis die IR-Bande der NCO Gruppe nicht mehr sichtbar ist. Es werden 10 g Bleioctoat und 10 g Cobaltoctoat sowie 44 g Ethylmethylketoxim zugegeben. Mit ca. 354 g Methoxypropylacetat-2 und ca. 852 g Lackbenzin wird auf eine ISO 6 Auslaufzeit von 38 s eingestellt.

Eine Leiterplatte wird in den Lack getaucht und dann 1 Stunde bei 90°C gehärtet. Der gebildete Film ist glatt und klebfrei. Der Gitterschnitt beträgt Gt 0 B (DIN 53151). Der Durchgangswiderstand nach DIN EN 60464-2 wird mit 1*10¹⁶ Ωcm⁻¹ bestimmt. Der TI über den Masseverlust an der Glasseide nach IEC 60216 beträgt 166. Mit dem Lack werden Drillstäbe nach IEC 61033 (Methode A) getränkt, und nach der Härtung (1 Stunde bei 110°C) wird die Verbackungsfestigkeit bestimmt. Sie beträgt bei 23°C 47 N.

### Beispiel 2

Aus 522 g (THEIC), 210 g NDC, 498 g Tallölfettsäure und 56 g eines technischen Gemisches von 2,6- und 2,4-Toluylendiisocyanat wird wie in Beispiel 1 beschrieben ein Harz hergestellt und analog mit den angegebenen Lösemitteln, Sikkativen und Antihautmittel formuliert. Der Lack ist gut lackier- und härtbar.
Der TI über den Masseverlust an der Glasseide nach IEC 60216 beträgt 157.

### Vergleichsbeispiel 3

Der Versuch aus Beispiel 1 wird wiederholt, nur daß das Harz nicht mit dem Gemisch aus 2,6- und 2,4-Toluylendiisocyanat modifiziert wird. Nach dem Lackieren und Aushärten werden klebrige Filme erhalten. Weitere Ausprüfungen erübrigen sich damit.

### Vergleichsbeispiel 4

Aus 1044 g (THEIC), 314 g Isophthalsäure, 1085g Tallölfettsäure und 208 g eines technischen Gemisches von 2,6- und 2,4-Toluylendiisocyanat wird wie in Beispiel 1 beschrieben ein Harz hergestellt und analog mit den angegebenen Lösemittel-, Sikkativ- und Antihautmittelmengen formuliert. Der Lack ist gut lackier- und härtbar. Der TI über den Masseverlust an der Glasseide nach IEC 60216 beträgt nur 140.

### Vergleichsbeispiel 5

Aus 536 g Trimethylolpropan, 460 g NDC, 1085g Tallölfettsäure und 208 g eines technischen Gemisches von 2,6- und 2,4-Toluylendiisocyanat wird wie in Beispiel 1 beschrieben ein Harz hergestellt und analog mit den angegebenen Lösemittel-, Sikkativ- und Antihautmittelmengen formuliert. Der Lack ist gut lackier- und härtbar. Der TI über den Masseverlust an der Glasseide nach IEC 60216 beträgt nur 139.

### Vergleichsbeispiel 6

Aus 536 g Trimethylolpropan, 314 g Isophthalsäure, 1085g Tallölfettsäure und 208 g eines technischen Gemisches von 2,6- und 2,4-Toluylendiisocyanat wird wie in Beispiel 1 beschrieben ein Harz hergestellt und analog mit den angegebenen Lösemittel-, Sikkativ- und Antihautmittelmengen formuliert. Der Lack ist gut lackier und härtbar. Der TI über den Masseverlust an der Glasseide nach IEC 60216 beträgt nur 132.

## Patentansprüche

1. Überzugslack enthaltend
a) ein Bindemittel bestehend aus einem Alkydharz aufgebaut aus
1. 33,0 - 50,0 Gew.-% Tris-(2-Hydroxyethyl)-Isocyanurat
2. 14,0 - 20,0 Gew.-% 2,6-Naphthalindicarbonsäuredimethylester,
3. 34,0 - 47,0 Gew.-% Tallölfettsäure
4. 1,0 - 15,0 Gew.-% Modifizierungsmittel
wobei die Gew.-% jeweils auf 100,0 Gew.-% addiert werden, und
wobei das Modifizierungsmittel ein Gemisch von 2,6- und 2,4-Toluylendiisocyanat ist,
b) wenigstens ein Lösemittel oder -gemisch enthaltend wenigstens ein kohlenwasserstoffhaltiges Lösemittelgemisch und
c) wenigstens ein Sikkativ oder wenigstens ein Gemisch von Sikkativen und ein oder mehrerer Antihautmittel.

2. Überzugslack nach Anspruch 1, **dadurch gekennzeichnet, daß** Komponente b) aliphatische oder aromatische Kohlenwasserstoffgemische oder Gemische hiervon enthält.

3. Überzugslack nach einem der vorhergehenden Ansprüche, **dadurch gekennzeichnet, daß** Komponente b) ein weiteres Lösemittel aus der Klasse der Ester, Ketone, Lactone oder Hydroxyether, Etherester, cyclische Ester enthält.

4. Überzugslack nach einem der vorhergehenden Ansprüche, **dadurch gekennzeichnet, daß** in Komponente c) Blei-, Cobalt-, Zirkonoctoat, Mangan-, Vanadium, Calciumnaphthenat oder Kombinationen eines oder mehrerer dieser Sikkative enthalten sind.

5. Überzugslack nach einem der vorhergehenden Ansprüche, **dadurch gekennzeichnet, daß** Komponente c) als Antihautmittel Ethylmethylketoxim, Tocopherol oder Gemische dieser Substanzen enthält.

6. Überzugslack nach einem der vorhergehenden Ansprüche, **dadurch gekennzeichnet, daß** Komponente c) zusätzlich Co-Katalysatoren, Korrosionsinhibitoren, Entschäumer, Verlaufs- und Netzmittel enthält.

7. Verfahren zur Herstellung eines Überzugslacks nach einem der Ansprüche 1 bis 6, **dadurch gekennzeichnet, daß** Komponente a) in Komponente b) gelöst gegebenenfalls erwärmt und anschließend Komponente c) zugegeben wird.

8. Verwendung des Überzugslacks nach einem der Ansprüche 1 bis 6 zum Beschichten von elektrischen Drähten und elektrischen Wicklungen, sowie als Überzug von Flachbaugruppen in der Elektronik, Hybriden, SMD-Baugruppen, bestückten Leiterplatten, zur Imprägnierung von elektrischen Wicklungen.

## Claims

1. Coating varnish comprising
a) a binder consisting of an alkyd resin synthesized from
1. 33.0% - 50.0% by weight of tris(2-hydroxyethyl)isocyanurate
2. 14.0% - 20.0% by weight of dimethyl 2,6-naphthalenedicarboxylate,
3. 34.0% - 47.0% by weight of tall oil fatty acid
4. 1.0% - 15.0% by weight of modifier
the percentages by weight adding up in each case to 100.0% by weight, and the modifier being a mixture of tolylene 2,6- and 2,4-diisocyanate,
b) at least one solvent or solvent mixture comprising at least one hydrocarbon-containing solvent mixture, and
c) at least one siccative or at least one mixture of siccatives and one or more antiskinning agents.

2. Coating varnish according to Claim 1, **characterized in that** component b) comprises aliphatic or aromatic hydrocarbon mixtures or mixtures thereof.

3. Coating varnish according to any one of the preceding claims, **characterized in that** component b) comprises a further solvent from the class of the esters, ketones, lactones or hydroxy ethers, ether esters or cyclic esters.

4. Coating varnish according to any one of the preceding claims, **characterized in that** component c) comprises lead, cobalt or zirconium octoate, manganese, vanadium or calcium naphthenate or combinations of one or more of these siccatives.

5. Coating varnish according to any one of the preceding claims, **characterized in that** component c) comprises as antiskinning agents ethyl methyl ketoxime, tocopherol or mixtures of these substances.

6. Coating varnish according to any one of the preceding claims, **characterized in that** component c) further comprises co-catalysts, corrosion inhibitors, defoamers, flow control agents, and wetting agents.

7. Process for preparing a coating varnish according to any one of Claims 1 to 6, **characterized in that** component a) is dissolved in component b), heated if desired, and then component c) is added.

8. Use of Coating varnish according to any one of Claims 1 to 6 for coating electrical wires and electrical windings, and also as a coating over flat modules in electronics, hybrids, SMD modules, assembled printed circuit boards, for impregnating electrical windings.

## Revendications

1. Laque de recouvrement, contenant
a) un liant constitué d'une résine alkyde formée à partir de
1. 33, 0-50, 0% en poids de tris-(2-hydroxyéthyl)-isocyanurate
2. 14,0-20,0% en poids d'ester diméthylique de l'acide 2,6-naphtalènedicarboxylique,
3. 34,0-47,0% en poids d'acide gras de tall oil
4. 1,0-15,0% en poids d'agent de modification
les % en poids s'ajoutant à chaque fois à 100% en poids et l'agent de modification étant un mélange de 2,6-toluylènediisocyanate et 2,4-toluylènediisocyanate,
b) au moins un solvant ou mélange de solvants contenant au moins un mélange de solvants hydrocarbonés et
c) au moins un dessiccateur ou au moins un mélange de dessiccateurs et un ou plusieurs agents empêchant la formation de croûtes.

2. Laque de recouvrement selon la revendication 1, **caractérisée en ce que** le composant b) contient des mélanges d'hydrocarbures aliphatiques ou aromatiques ou leurs mélanges.

3. Laque de recouvrement selon l'une quelconque des revendications précédentes, **caractérisée en ce que** le composant b) contient un autre solvant de la classe des esters, des cétones, des lactones ou des hydroxyéthers, des éther-esters, des esters cycliques.

4. Laque de recouvrement selon l'une quelconque des revendications précédentes, **caractérisée en ce que** le composant c) contient de l'octoate de plomb, de cobalt, de zirconium, du naphténate de manganèse, de vanadium, de calcium ou des combinaisons d'un ou de plusieurs de ces dessiccateurs.

5. Laque de recouvrement selon l'une quelconque des revendications précédentes, **caractérisée en ce que** le composant c) contient, comme agent empêchant la formation de croûtes, de l'éthylméthylcétoxime, du tocophérol ou des mélanges de ces substances.

6. Laque de recouvrement selon l'une quelconque des revendications précédentes, **caractérisée en ce que** le composant c) contient en outre des cocatalyseurs, des inhibiteurs de corrosion, des antimousses, des agents d'étalement et des agents mouillants.

7. Procédé pour la préparation d'une laque de recouvrement selon l'une quelconque des revendications 1 à 6, **caractérisé en ce que** le composant a) est dissous dans le b), le cas échéant chauffé et le composant c) est ajouté ensuite.

8. Utilisation de la laque de recouvrement selon l'une quelconque des revendications 1 à 6 pour le revêtement de fils et de bobines électriques ainsi que comme recouvrement de groupes bidimensionnels en électronique, d'hybrides, de groupes de pièces montées à plat (surface mounted devices, SMD), de circuits imprimés équipés, pour l'imprégnation de bobines électriques.
